(19) Europäisches Patentamt

European Patent Office

Office européen des brevets

(11) **EP 1 703 544 A2**

(12) **EUROPEAN PATENT APPLICATION**

(43) Date of publication:
**20.09.2006 Bulletin 2006/38**

(51) Int Cl.:
**H01L 21/00** (2006.01)

(21) Application number: **06002294.4**

(22) Date of filing: **03.02.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **14.03.2005 JP 2005070364**

(71) Applicant: **Matsushita Electric Industrial Co Ltd Kadoma-shi Osaka 571-8501 (JP)**

(72) Inventors:
• **Sugano, Kou Takatsuki-shi Osaka 569-0087 (JP)**

• **Miyoshi, Yuichi Katano-shi Osaka 576-0021 (JP)**
• **Adachi, Kazushige Takatsuki-shi Osaka 569-1022 (JP)**

(74) Representative: **Grünecker, Kinkeldey, Stockmair & Schwanhäusser Anwaltssozietät Maximilianstrasse 58 80538 München (DE)**

(54) **Chip holder and chip treatment method**

(57)     A chip holder includes: a lower holder plate with a first through hole; and an upper holder plate with a second through hole. An object to be treated is held movably in a holding space formed of the first through hole and the second through hole in assembling the lower holder plate and the upper holder plate.

FIG. 2

EP 1 703 544 A2

**Description**

BACKGROUND OF THE INVENTION

(a) Fields of the Invention

The present invention relates to chip holders used in semiconductor manufacturing equipment or the like, and in particular to chip holders used in cleaning equipment during semiconductor manufacturing and chip treatment methods using the chip holder.

(b) Description of Related Art

Conventionally, semiconductor devices are fabricated on a disk-shaped semiconductor substrate called wafer, and separated into respective chips. Thereafter, the separated chips are cleaned with pure water or the like and then dried.

In a chip drying process, individual chips made by dicing a semiconductor substrate are placed in a chip holder. The chip holder is provided with a plurality of recesses, and a predetermined number of chips are mounted thereinto. Through the bottoms of the recesses provided in the chip holder, air inlets are provided, respectively, which are connected to a vacuum system. By suction from the air inlets, the chips are fixed at their back sides to the chip holders, respectively. Then, air from nozzles positioned above the chip holders is blown on the surfaces of the chips, whereby the chips are dried.

In the case of using the chip holders mentioned above, however, the surface of the chip is completely dried on which air is blown directly, while the back side of the chip is incompletely dried which is in direct contact by suction with the chip holder. This causes possible troubles in later processes.

To solve this problem, for example, Patent Document 1 (Japanese Unexamined Patent Publication No. H7-176511) proposes a chip holder for conducting a drying treatment on semiconductor devices in the form of separate chips.

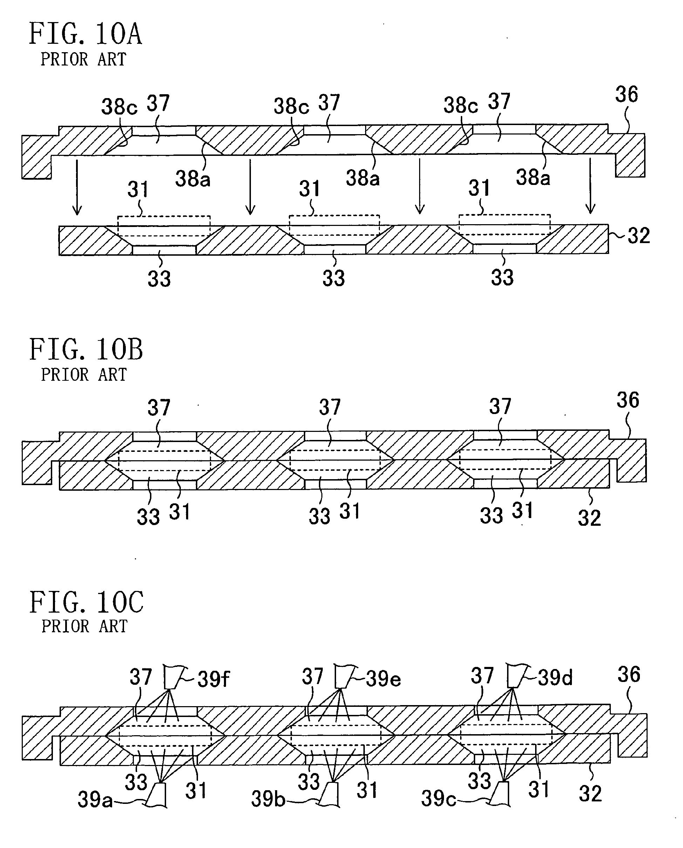

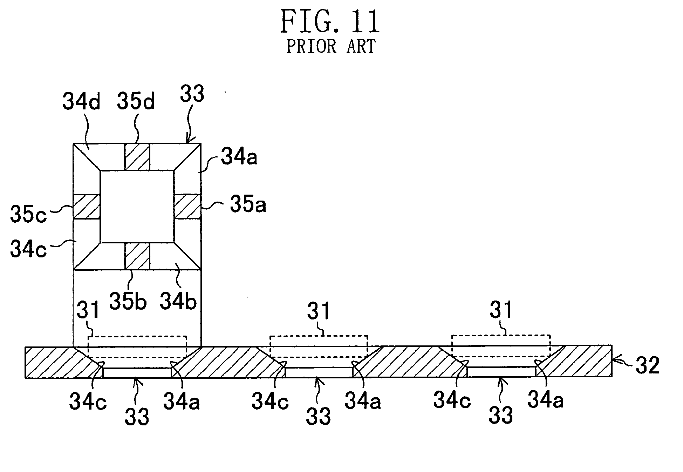

FIGS. **10A** to **10C** are sectional views showing process steps of a semiconductor chip drying method using a conventional chip holder disclosed in Patent Document 1. FIG. 11 is a view of the structure of the disclosed chip holder.

Referring to FIG. **10A,** first, a semiconductor substrate is subjected to predetermined semiconductor device manufacturing processes, and then diced into chips **31.** After the dicing, the chips **31** are each cleaned and placed inside first through holes **33** provided in a chip holder **32** as a placing portion of the chips, respectively. As shown in FIG. **11,** the chip holder **32** is formed with a predetermined number of first through holes **33,** and each of the first through holes **33** is formed with four tapered planes **34a** to **34d** according to the planar shape (quadrangular shape) of the chip **31.** That is to say, the chip **31** is placed inside the first through hole **33** in the state in which four edges (four sides) of the bottom surface of the chip **31** are in contact with the tapered planes **34a** to 34d, respectively. The tapered planes **34a** to **34d** are formed with grooves **35a** to 35d which extend thicknesswise of the chip holder **32,** respectively.

Note that the inclinations of the tapered planes **34a** to **34d,** that is, the taper angles thereof are determined according to the size of the semiconductor chip **31** to be placed. To be more specific, the taper angles of the tapered planes **34a** to **34d** are set at such values that a portion of the chip **31** placed in the first through hole **33** protrudes by a designated thickness above the surface of the chip holder **32.**

Next, as shown in FIG. **10A,** a cover **36** is prepared which is fitted to the chip holder **32** with the chips **31** placed therein. The cover **36** is formed with second through holes **37** associated with the first through holes **33.** Each of the second through holes 37 is formed with tapered planes **38a** to **38d** and grooves (not shown) having almost the same shapes as the tapered planes **34a** to **34d** and the grooves **35a** to **35d** of the first through hole 33, respectively.

As shown in FIG. **10B,** the cover **36** is put onto the chip holder **32.** At this time, the chip **31** is held within a space created by the first and second through holes **33** and **37.**

Subsequently, as shown in FIG. **10C,** air nozzles **39a** to **39c** are arranged below the first through holes **33** of the chip holder **32,** and air nozzles **39d** to **39f** are arranged above the second through holes **37** of the cover **36.** From these air nozzles **39a** to **39f,** air is blown to the top and bottom surfaces of the chips **31,** and thus the top and bottom surfaces of the chips **31** are simultaneously dried.

During this drying, air and water droplets blown by the air pass through the grooves **35a** to **35d** or the like provided in the tapered planes **34a** to **34d** and **38a** to **38d,** and they are then exhausted outside the first through holes **33** and the second through holes **37.** In other words, air and water droplets are exhausted from gaps between the chip holder **32** and the chips **31.** Also, air passes through the grooves **35a** to **35d** or the like in the tapered planes **34a** to **34d** and **38a** to **38d,** which also allows an efficient drying of the side surfaces of the chips **31.**

SUMMARY OF THE INVENTION

To conventional LSIs, a manufacturing method has been applied in which semiconductor devices are fully fabricated on a semiconductor substrate using semiconductor processing technology and then the substrate is diced into chips. In recent years, such semiconductor processing technology has been applied not only to manufacturing of conventional semiconductor devices such as LSIs but also to manufacturing of MEMS (Micro Electro Mechanical Systems) devices and the like. The MEMS devices have microstructures. Therefore, if the manufacturing method applied to the conventional LSIs is applied to manufacturing of the MEMS devices, physical stress placed during the dicing into chips would break the devices themselves, depending on the structures of the MEMS device.

To prevent this trouble, the following approach is employed. Fabrication of MEMS devices on a semiconductor substrate (wafer) is carried out until some midpoint of the manufacturing process. Then, the resulting wafer is diced to separate the MEMS devices in chip form, and a final process is conducted on each device.

In the case where a wafer after fabrication of semiconductor devices such as LSIs is diced into separate chips and after chip cleaning, the chips are dried only, in order to ventilate air blown to the chips and exhaust water droplets and the like adhering onto the chips, it is sufficient to provide a slight gap between the chip holder and the chip, as shown above.

On the other hand, in the case of fabricating MEMS devices, it becomes necessary to carry out, after the dicing of the wafer into separate chips, process steps such as etching for forming each chip in a desired shape, cleaning of the chips, and drying accompanying the cleaning. However, the chip holder disclosed in Patent Document 1 has a small gap between the chip and the chip holder. This decreases the displacement efficiency and the exhaust efficiency of liquid such as etching solution, cleaning solution, or pure water, which brings about a problem that it takes a significantly long time to conduct a cleaning treatment.

With the foregoing in mind, an object of the present invention is to enhance the cleaning efficiency of chips held in a chip holder.

To attain the above object, the inventors made various studies and then found an inventive chip holder capable of movably holding objects to be treated such as chips. With this chip holder, a plurality of supply and drainage channels of fluid such as cleaning solution can be secured in the chip holder, so that the displacement efficiency and the exhaust efficiency of the fluid can be enhanced. In addition to this, the contact area of the chip holder with the chips can be reduced. Consequently, cleaning of the chips in the state of being held by the chip holder can enhance the cleaning efficiency of the chips.

To be more specific, a chip holder according to the present invention includes: a lower holder plate with a first through hole; and an upper holder plate with a second through hole, and an object to be treated is held movably in a holding space formed of the first through hole and the second through hole in assembling the lower holder plate and the upper holder plate.

With the chip holder of the present invention, in the holding space formed of the first through hole of the lower holder plate and the second through hole of the upper holder plate, the object to be treated is held in a movable state, that is, in a point-contact or non-contact state. This enhances the displacement efficiency and the exhaust efficiency of fluid such as cleaning liquid introduced from the first through hole or the second through hole in treating the object to be treated, and concurrently reduces the contact area of the chip holder with the object to be treated. Therefore, by performing a cleaning with the object to be treated held in the chip holder, the cleaning efficiency of the object to be treated can be improved. In addition, accumulation of dust or the like within the chip holder can be prevented.

Preferably, in the chip holder of the present invention, the first through hole includes: a first maximum opening plane having, in an upper surface of the lower holder plate, an area equal to or larger than the maximum projection area of the object to be treated; and a first minimum opening plane having, between the upper and lower surfaces of the lower holder plate, a smaller area than the maximum projection area, and the second through hole includes: a second maximum opening plane having, in a lower surface of the upper holder plate, an area equal to or larger than the maximum projection area; and a second minimum opening plane having, between the upper and lower surfaces of the upper holder plate, a smaller area than the maximum projection area.

With this holder, the object to be treated can be certainly prevented from going out of the holding space of the chip holder, and concurrently the object to be treated can be held movably in the holding space.

Note that in the case where the object to be treated is, for example, a chip, the maximum projection area of the object to be treated indicates the area of the largest surface of the chip (that is, the top or back surface of the chip).

Preferably, in the above case, in the lower surface of the lower holder plate, the first through hole has a larger opening plane than the first minimum opening plane.

With this holder, the exhaust efficiency of fluid such as cleaning liquid, which is introduced into the holding space of the chip holder, from the first through hole is further improved, so that the cleaning efficiency of the object to be treated is further enhanced.

Preferably in the above case, in the upper surface of the upper holder plate, the second through hole has a larger opening area than the second minimum opening area.

With this holder, the exhaust efficiency of fluid such as cleaning liquid, which is introduced into the holding space of the chip holder, from the second through hole is further improved, so that the cleaning efficiency of the object to be treated is further enhanced.

Moreover, in the above case, it is preferable that: in the upper surface side of the lower holder plate, the first through hole includes a lower-plate conical hole with no cone point; in the lower surface side of the upper holder plate, the second through hole includes an upper-plate conical hole with no cone point; the first maximum opening plane is the bottom of the lower-plate conical hole; and the second maximum opening plane is the bottom of the upper-plate conical hole.

With this holder, the holding space of the chip holder is formed of the lower-plate conical hole and the upper-plate conical hole. Further, even when the object to be treated comes into contact with a wall of the lower-plate conical hole or the upper-plate conical hole, the object to be treated can be held reliably in a point-contact state. This allows certain enhancement of the displacement efficiency and the exhaust efficiency of fluid such as cleaning liquid introduced into the holding space, which certainly improves the cleaning efficiency of the object to be treated.

Preferably, in the chip holder of the present invention, the upper surface of the lower holder plate is provided with a groove extending from the first through hole to a side edge of the lower holder plate.

With this holder, the supply efficiency and the exhaust efficiency of fluid such as cleaning liquid into and from the holding space of the chip holder are still further enhanced, so that the cleaning efficiency of the object to be cleaned is still further enhanced.

Preferably, in the above case, the lower holder plate has another through hole adjacent to the first through hole, and the groove extends from the first through hole to another said through hole. With this holder, the supply path of fluid such as cleaning liquid into the holding space of the chip holder and the exhaust path of fluid from the holding space are secured in multiple directions. Thus, the supply efficiency and the exhaust efficiency of fluid into and from the holding space are still further enhanced, so that the cleaning efficiency of the object to be treated is still further enhanced.

Preferably, in the above case, an outermost perimeter of the upper surface of the lower holder plate is provided with a level difference. With this holder, a gap connected to the groove is created at the side edge of the chip holder. As a result of this, the effect of fluid regulation at the side edge enhances the displacement efficiency, through the groove, of the fluid within the holding space of the chip holder, so that the cleaning efficiency of the object to be treated can be still further enhanced.

Preferably, in the chip holder of the present invention, the lower surface of the upper holder plate is provided with a groove extending from the second through hole to a side edge of the upper holder plate.

With this holder, the supply efficiency and the exhaust efficiency of fluid such as cleaning liquid into and from the holding space of the chip holder are still further enhanced, so that the cleaning efficiency of the object to be cleaned is still further enhanced.

Preferably, in the above case, the upper holder plate has another through hole adjacent to the second through hole, and the groove extends from the second through hole to another said through hole. With this holder, the supply path of fluid such as cleaning liquid into the holding space of the chip holder and the exhaust path of fluid from the holding space are secured in multiple directions. Thus, the supply efficiency and the exhaust efficiency of fluid into and from the holding space are still further enhanced, so that the cleaning efficiency of the object to be treated is still further enhanced.

Preferably, in the above case, an outermost perimeter of the lower surface of the upper holder plate is provided with a level difference. With this holder, a gap connected to the groove is created at the side edge of the chip holder. As a result of this, the effect of fluid regulation at the side edge enhances the displacement efficiency, through the groove, of the fluid within the holding space of the chip holder, so that the cleaning efficiency of the object to be treated can be still further enhanced.

Preferably, in the chip holder of the present invention, with the lower and upper holder plates assembled, a gap of a height smaller than the thickness of the object to be treated is created between the lower and upper holder plates.

With this holder, the supply path of fluid such as cleaning liquid into the holding space of the chip holder and the exhaust path of fluid from the holding space are secured in multiple directions. In addition, the effect of fluid regulation facilitates entry of the fluid into the groove. Therefore, the supply efficiency and the exhaust efficiency of fluid into and from the holding space are still further enhanced, so that the cleaning efficiency of the object to be treated is still further enhanced.

Preferably, in the chip holder of the present invention, a bar covering a portion of the first through hole is provided on the lower surface of the lower holder plate.

With this holder, an impact can be softened which is given to the object to be treated by fluid such as cleaning liquid introduced into the holding space of the chip holder. Therefore, even if the object to be treated is a structurally-weak device, breakage of the device can be prevented and concurrently the displacement efficiency and the exhaust efficiency of fluid within the holding space can be enhanced. This improves the cleaning efficiency of the device.

Preferably, in the chip holder of the present invention, a bar covering a portion of the second through hole is provided on the upper surface of the upper holder plate.

With this holder, an impact can be softened which is given to the object to be treated by fluid such as cleaning liquid introduced into the holding space of the chip holder. Therefore, even if the object to be treated is a structurally-weak device, breakage of the device can be prevented and concurrently the displacement efficiency and the exhaust efficiency of fluid within the holding space can be enhanced. This improves the cleaning efficiency of the device.

Preferably, in the chip holder of the present invention, the object to be treated differs from the holding space in planer shape.

With this holder, when the object to be treated comes into contact with a wall of the first through hole or the second through hole forming the holding space, the contact is always made in a point-contact state. Thus, the object to be treated can be reliably held in the holding space of the chip holder in a point-contact or non-contact state. This allows certain enhancement of the displacement efficiency and the exhaust efficiency of fluid such as cleaning liquid introduced into the holding space, which certainly improves the cleaning efficiency of the object to be treated. To be more specific, the planer shape of the object to be treated may be a quadrangle, and the planer shape of the holding space may be a circle, an ellipse, or a polygon with five or more comers.

Note that in the case where the object to be treated is, for example, a chip, the planer shape of the object to be treated indicates the shape of the chip when viewed from the top surface (that is, the shape of the top or back surface of the chip), and the planer shape of the holding space indicates the shape of the holding space when viewed from the top surface of the upper holder plate (specifically, the shape of the first maximum opening plane of the first through hole or the shape of the second maximum opening plane of the second through hole).

A chip treatment method according to the present invention carries out treatment on the object to be treated with the object to be treated held in the above-described chip holder of the present invention. To be more specific, during the treatment, the object to be treated is cleaned by subjecting the object to be treated to fluid, or the object to be treated is dried. With this method, when the object to be treated is cleaned, the cleaning efficiency of the object to be treated can be enhanced as described above. Moreover, the contact area of the chip holder with the object to be treated is small. Therefore, when the object to be treated is dried, a sufficient drying of the object to be treated can be carried out. This provides a reliable prevention of a situation in which possible troubles occur in later processes.

As is apparent from the above, the present invention relates to chip holders used in semiconductor manufacturing equipment or the like. When the present invention is applied to a chip cleaning treatment carried out in manufacturing MEMS devices, the cleaning efficiency of the object to be treated can be improved, which is of very usefulness.

BRIEF DESCRIPTION OF THE DRAWINGS

FIGS. **1A** and **1B** are views showing a schematic structure of a chip holder according to a first embodiment of the present invention. FIGS. **1C** and **1D** are views showing a cross-sectional structure of through hole formation regions of lower and upper holder plates of the chip holder according to the first embodiment of the present invention.

FIG. **2** is a view for giving a brief explanation of a chip cleaning method using the chip holder according to the first embodiment of the present invention.

FIG. **3** is a schematic view showing the flow of fluid within the chip holder according to the first embodiment of the present invention.

FIGS. **4A** and **4B** are views showing a cross-sectional structure of through hole formation regions of lower and upper holder plates of a chip holder according to one modification of the first embodiment of the present invention.

FIGS. **5A** and **5B** are views showing a schematic structure of a chip holder according to a second embodiment of the present invention. FIG. **5C** is a view showing a cross-sectional structure of through hole formation regions of lower and upper holder plates of the chip holder according to the second embodiment of the present invention. FIG. **5D** is a schematic view showing the flow of fluid within the chip holder shown in FIGS. **5A** to **5C**.

FIGS. **6A** and **6B** are views showing a schematic structure of a chip holder according to a third embodiment of the present invention. FIG. **6C** is a view showing a cross-sectional structure of through hole formation regions of lower and upper holder plates of the chip holder according to the third embodiment of the present invention.

FIGS. **7A** and **7B** are views showing a schematic structure of a chip holder according to a fourth embodiment of the present invention. FIG. **7C** is a view showing a cross-sectional structure of through hole formation regions of lower and upper holder plates of the chip holder according to the fourth embodiment of the present invention. FIG. **7D** is a schematic view showing the flow of fluid within the chip holder shown in FIGS. **7A** to **7C.**

FIGS. **8A** and **8B** are diagrams for explaining the condition in which a chip does not go out of a holding space of the chip holder according to the first to fourth embodiments of the present invention.

FIGS. **9A** and **9B** are views showing an exemplary arrangement of chip holding spaces of the chip holder according to the first to fourth embodiments of the present invention.

FIGS. **10A** to **10C** are sectional views showing process steps of a semiconductor chip drying method using a conventional chip holder disclosed in Patent Document 1.

FIG. **11** is a view showing the structure of the conventional chip holder disclosed in Patent Document 1.

DETAILED DESCRIPTION OF THE PREFERRED EMBODIMENTS

(First Embodiment)

Hereinafter, a chip holder and a chip treatment method (specifically, chip cleaning method) according to a first embodiment of the present invention will be described with reference to the accompanying drawings.

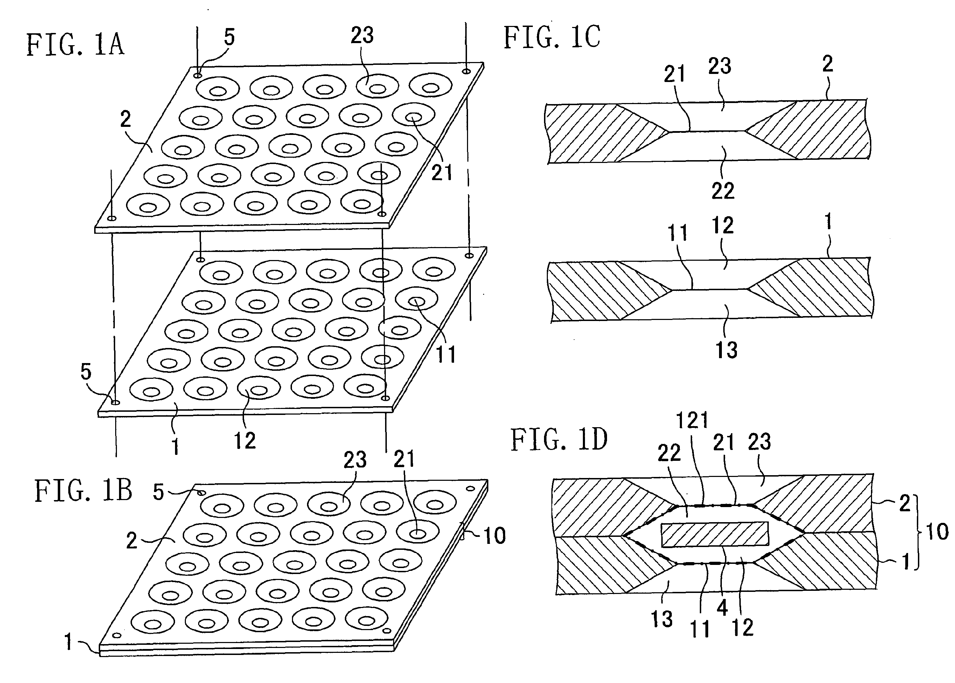

FIGS. **1A** and **1B** are views showing a schematic structure of a chip holder according to the first embodiment. FIG. **1A** shows the chip holder in the state prior to assembly of a lower holder plate and an upper holder plate thereof, while FIG. **1B** shows the chip holder in the state subsequent to the assembly of those plates.

FIGS. **1C** and **1D** are views showing a cross-sectional structure of through hole formation regions of the lower and upper holder plates of the chip holder according to the first embodiment. FIG. **1C** shows the chip holder in the state prior to assembly of the lower and upper holder plates, while FIG. **1D** shows the chip holder in the state subsequent to the assembly of those plates.

Referring to FIGS. **1A** and **1C,** through the upper surface of a lower holder plate **1** with a thickness of, for example, 1.0 mm, a predetermined number of first conical holes (lower-plate conical holes (the inner side)) **12** as first openings are formed which have no cone points. When the chip holder of the first embodiment is used for cleaning of chips having a dimension of, for example, 2 mm (width) x 2 mm (length) x 0.4 mm (thickness), the bottom opening of each of the first conical holes **12** (a maximum opening plane of the upper surface of the lower holder plate **1)** has a diameter of, for example, 3.8 mm and the top opening thereof (a minimum opening plane **11** at the interface between the upper and lower surfaces of the lower holder plate 1) has a diameter of, for example, 2.2 mm. Through the lower surface of the lower holder plate **1,** a predetermined number of second conical holes (lower-plate conical holes (the outer side)) **13** as second openings are formed which have no cone points. The first and second conical holes **12** and **13** are symmetric with respect to the minimum opening plane **11.** That is to say, the lower holder plate 1 is provided with a predetermined number of first through holes formed of the first and second conical holes **12** and **13.** Note that in the first embodiment, the first and second conical holes **12** and **13** have the same shape.

Further, as shown in FIGS. **1A** and **1C,** through the lower surface of an upper holder plate **2** with a thickness of, for example, 1.0 mm, a predetermined number of third conical holes (upper-plate conical holes (the inner side)) **22** as third openings are formed which have no cone points. The third conical holes **22** are provided in the upper holder plate **2** so that in assembling the upper and lower holder plates **2** and **1,** the maximum opening planes of the first conical holes **12** formed in the lower holder plate 1 match with the maximum opening planes of the third conical holes **22,** respectively. That is to say, the upper holder plate **2** is provided with the third conical holes **22** equal in shape and number to the first conical holes **12.** Specifically, when the chip holder of the first embodiment is used for cleaning of chips having a dimension of, for example, 2 mm (width) x 2 mm (length) x 0.4 mm (thickness), the bottom opening of each of the third conical holes **22** (a maximum opening plane of the lower surface of the upper holder plate 2) has a diameter of, for example, 3.8 mm and the top opening thereof (a minimum opening plane **21** at the interface between the upper and lower surfaces of the upper holder plate 2) has a diameter of, for example, 2.2 mm. Through the upper surface of the upper holder plate 2, a predetermined number of fourth conical holes (upper-plate conical holes (the outer side)) **23** as fourth openings are formed which have no cone points. The third and fourth conical holes **22** and **23** are symmetric with respect to the minimum opening plane **21.** That is to say, the upper holder plate **2** is provided with a predetermined number of second through holes formed of the third and fourth conical holes **22** and **23.** Note that in the first embodiment, the third and fourth conical holes **22** and **23** have the same shape.

Referring to FIGS. **1B** and **1D,** the case where objects to be treated are held in a chip holder **10** of the first embodiment is considered. First, for example, chips **4** to be cleaned are placed in the first conical holes **12** provided in the lower holder plate **1.** Next, the upper holder plate **2** is put onto the lower holder plate 1 so that the first conical holes **12** match with the second conical holes **22,** respectively. Then, set screws (not shown) are inserted into set screw holes **5** formed at, for example, respective four corners of the lower and upper holder plates **1** and **2,** thereby fixing the lower and upper holder plates **1** and **2.** In this manner, the chips **4** are held in chip holding spaces **121** formed of the first conical holes **12** in the lower holder plate **1** and the third conical holes **22** in the upper holder plate **2,** respectively.

As described above, each of the chip holding spaces **121** is formed of the two conical holes **12** and **22.** Therefore, the center portion of the space widens, so that in the first embodiment, the chip **4** can move in all of X direction (width direction), Y direction (length direction), and Z direction (thickness direction).

To be more specific, in the first embodiment, the areas of the minimum opening planes **11** and **21** of the first and third conical holes **12** and **22** (in the case described above, the area is: $3.14 \times 1.1 \times 1.1 \approx 3.8$ mm$^2$) are set to be smaller than the maximum projection area of the chip **4** (that is, the area of the top or back surface of the chip **4** which is the maximum surface thereof: in the case described above, $2 \times 2 = 4$ mm$^2$). In other words, the diameters of the minimum opening planes **11** and **21** of the first and third conical holes **12** and **22** (in the case described above, 2.2 mm) are set to be smaller than the length of the diagonal line of the chip **4** (in the case described above, about 2.8 mm). It goes without saying that the areas of the maximum opening planes of the first and third conical holes **12** and **22** (that is, the horizontal cross-sectional area of the center portion of the chip holding space **121)** are larger than the maximum projection area of the chip **4.**

With the structure shown above, the chip **4** can be certainly prevented from going out of the chip holding space **121** of the chip holder **10** of the first embodiment, and concurrently the chip **4** can be held in the chip holding space **121** in a movable state, that is, in a point-contact or non-contact state. Namely, the planer shape of the chip **4** (that is, the shape of the top or back surface of the chip (quadrangle)) is different from the planer shape of the chip holding space **121** formed of the first and third conical holes **12** and **22** (the shape of the maximum opening plane of the first conical hole **12** or the third conical hole **22** (circle)). Thus, the chip **4** can be held in the chip holding space **121** in a non-contact state, and contact of the chip **4** with a wall of the first conical hole **12** or a wall of the third conical hole **22** is always made in a point-contact state.

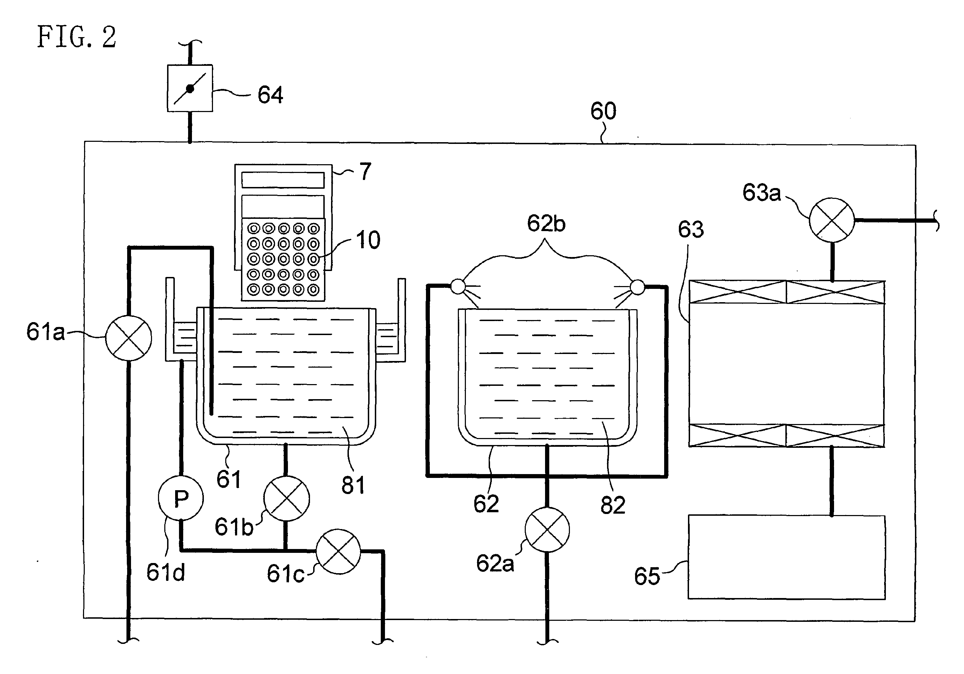

Next, a method for cleaning chips held in the chip holder **10** according to the first embodiment will be described below with reference to FIG. **2.**

FIG. **2** is a view for giving a brief explanation of the chip cleaning method using the chip holder **10** according to the first embodiment (which is employed for brief explanations of chip cleaning methods using a chip holder according to second to fourth embodiments). Referring to FIG. **2,** the chip holder **10** with chips held therein is supported manually by, for example, an arm 7. To a cleaning bath **61** for performing a chip cleaning, cleaning liquid 81 is supplied by opening an open/close valve **61a** for a cleaning liquid supply line. The cleaning liquid **81** can be circulated by opening a circulating valve **61b,** closing a waste liquid valve **61c,** and driving a circulating pump **61d.** A water washing bath 62 for performing a chip washing with water is, for example, an overflow bath. By opening a pure water supply valve **62a,** pure water **82** is supplied into the water washing bath **62** from the bottom of the bath, and simultaneously with this, pure water **82** is supplied also from a shower nozzle **62b** into the water washing bath **62.** A drying furnace **63** for performing a chip drying is kept at a constant temperature by a temperature control system **65.** By opening an open/close valve **63a** for a nitrogen supply line, nitrogen is supplied into the drying furnace **63.** The cleaning bath **61,** the water washing bath **62,** and the drying furnace **63** are surrounded with a housing **60,** and the inside of the housing **60** is kept at reduced pressure by an exhaust valve **64.**

A chip cleaning procedure is as follows. First, the open/close valve **61a** for the cleaning liquid supply line is opened to supply a desired amount of cleaning liquid **81** to the cleaning bath **61.** Then, with the circulating valve **61b** opened and the waste liquid valve **61c** closed, the circulating pump **61d** is driven to circulate the cleaning liquid **81.** While the chip holder **10** is supported by the arm **7,** the chip holder **10** is immersed for a desired period of time in the cleaning liquid **81** stored in the cleaning bath **61.** Then, the chip holder **10** is moved to the water washing bath **62** into which the pure water **82** is supplied in advance by opening the pure water supply valve **62a,** and the chip holder **10** is immersed for a desired period of time in the pure water **82** stored in the water washing bath **62.** After completion of water washing in the water washing bath **62,** the chip holder **10** is moved to the drying furnace **63** which has been previously controlled at a fixed temperature by a temperature control system **65** and which is kept in a nitrogen atmosphere by opening the open/close valve **63a** for a nitrogen supply line. Then, a drying treatment is conducted for a desired period of time.

In the first embodiment, description has been made of an exemplary case where one type of chemical solution is used for the chip cleaning treatment. However, according to need, a fluid supply line can be added to perform a chip cleaning treatment with multiple types of chemical solutions. Moreover, in the first embodiment, immediately after water washing with pure water, the chip holder **10** is put into the drying furnace **63.** Instead of this, after water washing with pure water, chip moisture may be removed with solvent such as HFE (hydrofluoroether) and then the chip holder **10** may be inserted into the drying furnace **63.**

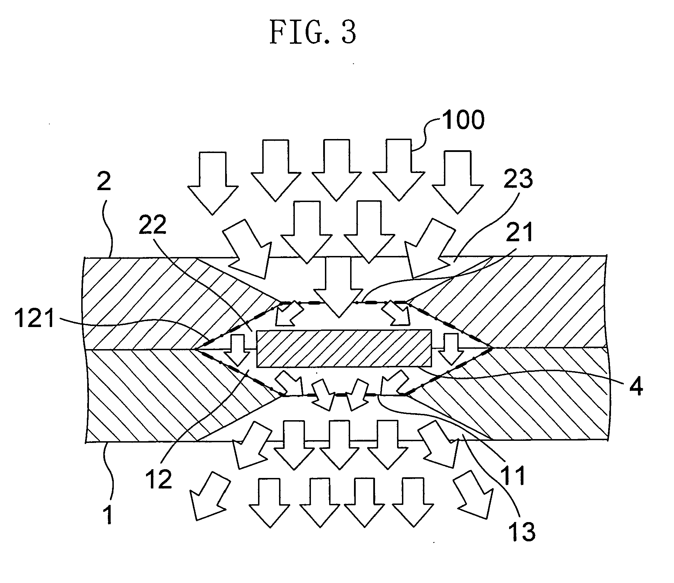

Next, the flow of fluid (cleaning liquid, pure water, or the like) inside the chip holder **10** according to the first embodiment description will be described with reference to FIG 3.

FIG. 3 is a schematic view showing the flow of fluid supplied and exhausted in the cleaning treatment using the chip holder **10** according to the first embodiment.

Referring to FIG. **3,** fluid **100** is supplied from the fourth conical hole **23** of the upper holder plate 2 into the chip holder **10.** The supplied fluid **100** passes through the minimum opening plane **21** to enter the chip holding space **121,** and comes into contact with the chip **4.** The fluid **100** coming into contact with the chip **4** then passes through the minimum opening plane **11** and the second conical hole **13** and is exhausted.

As described above, in the first embodiment, the chip **4** is kept movably in the chip holding space **121.** From this, the contact spot of the chip holder **10** with the chip **4** always varies in location, and therefore the area of the contact spot can be decreased. As a result, the fluid can come into contact with the whole surfaces of the chip **4.** Furthermore, a path of the fluid is always secured within the chip holding space **121.** Therefore, the displacement efficiency and the exhaust efficiency of the fluid can be enhanced, and thereby the cleaning efficiency of the chip **4** can be improved. In addition, accumulation of dust or the like within the chip holder **10** can be prevented.

Furthermore, in the first embodiment, the lower holder plate **1** is provided with the first through hole which is formed of the first and second conical holes **12** and **13** arranged with the minimum opening plane **11** interposed therebetween, while the upper holder plate **2** is provided with the second through hole which is formed of the third and fourth conical holes **22** and **23** arranged with the minimum opening plane **21** interposed therebetween. In other words, the first through hole of the lower holder plate **1** is provided with the maximum opening planes located on both of the upper and lower surfaces of the lower holder plate **1** (a pair of maximum opening planes provided to interpose the minimum opening plane **11),** while the second through hole of the upper holder plate **2** is provided with the maximum opening planes located on both of the upper and lower surfaces of the upper holder plate **2** (a pair of maximum opening planes provided to interpose the minimum opening plane **21).** This enhances the exhaust efficiency of fluid such as cleaning liquid, which is introduced into the chip holding space **121,** from the first or second through hole, which also enhances the displacement efficiency of the fluid. Therefore, the cleaning efficiency of the chip **4** can be still further improved. In addition, also when the chip holder **10** of the first embodiment is used to dry the chip 4, fluid within the chip holding space **121** can be exhausted quickly from the first or second through hole. As a result, the time required for drying can be cut.

Moreover, in the first embodiment, the lower and upper holder plates **1** and **2** have the same structure, so that their respective uses can be exchanged with each other. That is to say, the upper and lower holder plates can be employed without distinction, which enhances the convenience of the holder.

(Modification of First Embodiment)

Hereinafter, a chip holder and a chip treatment method according to one modification of the first embodiment of the present invention will be described with reference to the accompanying drawings.

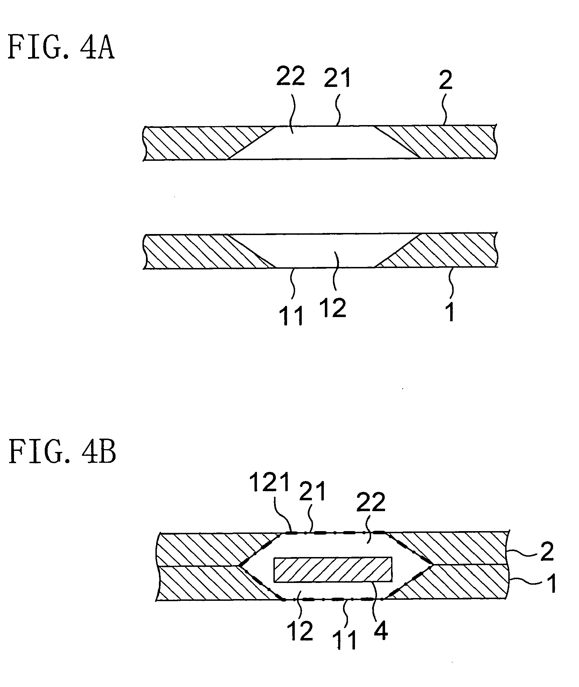

FIGS. **4A** and **4B** are views showing a cross-sectional structure of through hole formation regions of lower and upper holder plates of the chip holder according to this modification. FIG. **4A** shows the chip holder in the state prior to assembly of the lower and upper holder plates, while FIG. **4B** shows the chip holder in the state subsequent to the assembly of those plates. Note that the description of the components shown in FIGS. **4A** and **4B** that are the same as those of the first embodiment shown in FIGS. **1A** to **1D** will be omitted by retaining the same reference numerals.

This modification differs from the first embodiment in the shapes of through holes provided through the lower holder plate 1 and the upper holder plate **2,** respectively, as shown in FIGS. **4A** and **4B.** To be more specific, in the first embodiment, as shown in FIGS. **1C** and **1D,** the first through hole formed of the first and second conical holes **12** and **13** is provided through the lower holder plate **1,** and the second through hole formed of the third and fourth conical holes **22** and **23** is provided through the upper holder plate **2.** On the other hand, in this modification, as shown in FIGS. **4A** and **4B,** a first through hole formed only of the first conical hole **12** is provided through the lower holder plate **1,** and a second through hole formed only of the third conical hole **22** is provided through the upper holder plate **2.** That is to say, a maximum opening plane of the first conical hole **12** as the first through hole is positioned on the upper surface side of the lower holder plate **1,** and a minimum opening plane **11** of the first conical hole **12** is positioned on the lower surface side of the lower holder plate **1.** Also, a maximum opening plane of the third conical hole **22** as the second through hole is positioned on the lower surface side of the upper holder plate **2,** and a minimum opening plane **21** of the third conical hole **22** is positioned on the upper surface side of the upper holder plate **2.**

As shown in FIG. **4B,** also in this modification, similarly to the first embodiment, the chip **4** is held in the chip holding space **121** formed of the first conical hole (first through hole) **12** provided through the lower holder plate **1** and the third conical hole (second through hole) **22** provided through the upper holder plate **2.**

The chip holder of this modification described above can be employed instead of the chip holder of the first embodiment in accordance with fluid for use in cleaning, the technique of drying, or the like. The chip holder and the chip treatment method using that holder according to this modification can provide the same effects as the first embodiment.

Note that in this modification, depending on the material forming the chip holder, the necessity to increase the thicknesses of the lower and upper holder plate **1** and **2** or to take measures to reinforce the lower and upper holder plates **1** and **2** may arise in order to maintain the respective strengths of the lower and upper holder plates **1** and **2.**

(Second Embodiment)

Hereinafter, a chip holder and a chip treatment method (specifically, chip cleaning method) according to a second embodiment of the present invention will be described with reference to the accompanying drawings.

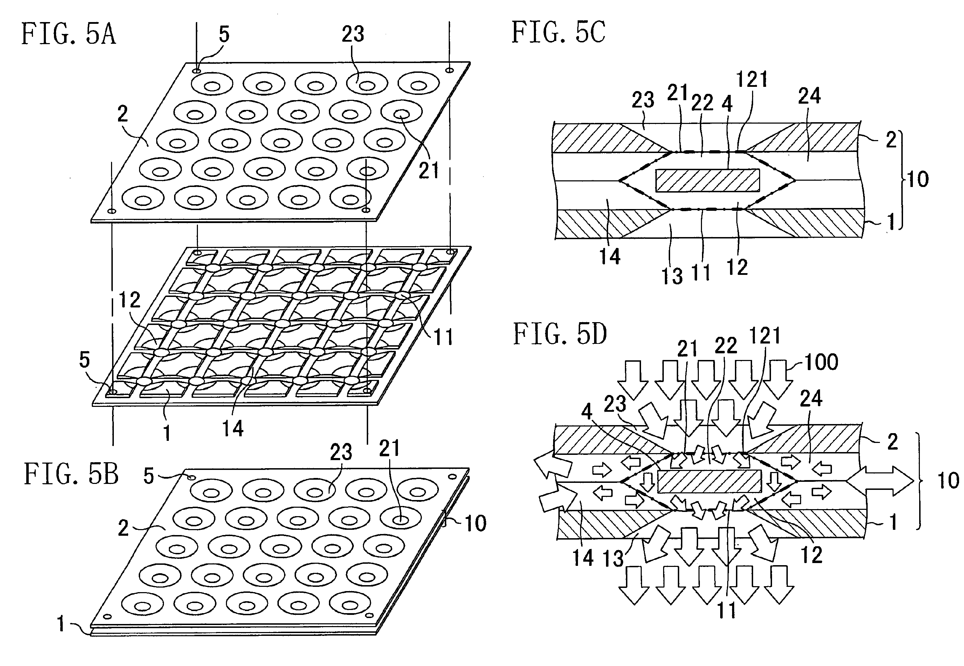

FIGS. **5A** and **5B** are views showing a schematic structure of a chip holder according to the second embodiment. FIG. **5A** shows the chip holder in the state prior to assembly of a lower holder plate and an upper holder plate, while FIG. **5B** shows the chip holder in the state subsequent to the assembly of those plates.

FIG. **5C** is a view showing a cross-sectional structure of through hole formation regions of the lower and upper holder plates of the chip holder according to the second embodiment. **FIG. 5C** shows the chip holder in the state subsequent to the assembly of the lower and upper holder plates.

FIG. **5D** is a schematic view showing the flow of fluid supplied and exhausted in a cleaning treatment using a chip holder **10** according to the second embodiment shown in FIGS. **5A** to **5C**.

Note that the description of the components shown in FIGS. **5A** to **5D** that are the same as those of the first embodiment shown in FIGS. **1A** to **1D** will be omitted by retaining the same reference numerals.

A first point of the second embodiment different from the first embodiment is that, as shown FIGS. **5A** to **5C,** in order to enhance the supply efficiency and the exhaust efficiency of fluid such as cleaning liquid within the chip holding space **121,** the upper surface of the lower holder plate 1 is provided with a plurality of grooves (lower plate grooves) 14 connecting adjacent first conical holes **12** and extending to side edges of the lower holder plate **1,** and that the lower surface of the upper holder plate **2** is provided with a plurality of grooves (upper plate grooves) **24** connecting adjacent third conical holes **22** and extending to side edges of the upper holder plate **2.** When the chip holder of the second embodiment is used for cleaning of chips having a dimension of, for example, 2 mm (width) x 2 mm (length) $\times$ 0.4 mm (thickness), the grooves **14** and **24** have a width of, for example, 1.0 mm and a depth of, for example, 0.5 mm. The bottom surface of each groove **14** is flush with the minimum opening plane **11,** and the bottom surface of each groove **24** (the top surface in this figure) is flush with the minimum opening plane **21.**

A second point of the second embodiment different from the first embodiment is that as shown in FIGS. **5A** to **5C**, the perimeter of the lower holder plate **1** is provided with a level difference so that the upper surface of the perimeter is flush with the bottom surface of the groove **14,** and that the perimeter of the upper holder plate **2** is provided with a level difference so that the lower surface of the perimeter is flush with the bottom surface of the groove **24** (the top surface in this figure). From this, in the chip holder **10** of the second embodiment made by assembling the lower holder plate **1** and the upper holder plate 2 (see FIG. **5B),** a side edge thereof is formed with a gap of a predetermined height (which is made by uniting the grooves **14** and **24).** When the chip holder of the second embodiment is used for cleaning of chips having a dimension of, for example, 2 mm (width) $\times$ 2 mm (length) x 0.4 mm (thickness), each level difference has a height of, for example, 0.5 mm and a length of, for example, 1.0 mm. In this case, the perimeter of the chip holder **10** of the second embodiment (see FIG. **5B)** is formed with a gap having a height of 1.0 mm.

As shown in FIG. **5D,** into the chip holder **10** of the second embodiment, fluid **100** is supplied from the fourth conical hole **23** of the upper holder plate **2.** The supplied fluid **100** passes through the minimum opening plane **21** to enter the chip holding space **121,** and comes into contact with the chip **4.** In the first embodiment, the fluid **100** coming into contact with the chip **4** then passes through the minimum opening plane **11** and the second conical hole **13** and is exhausted (see FIG. **3).** In contrast to this, in the chip holder **10** of the first embodiment, the groove **14** shown in, for example, FIG. **5A** extends to connect adjacent first conical holes **12.** Therefore, as shown in FIG. **5D,** the fluid **100** coming into contact with the chip **4** then not only passes through the minimum opening plane **11** and the second conical hole **13** and is exhausted, but also passes from the first conical hole **12** through the groove **14** and is exhausted in four directions.

With the chip holder and the chip treatment method using that holder described above according to the second embodiment, in addition to the same effects as the first embodiment, the following effects can be exerted. To be more specific, the chip holding space **121** formed of the first and third conical holes **12** and **22** provided through the lower and upper holder plates **1** and **2,** respectively, has six passages of fluid (cleaning liquid or the like) in six directions in total, of which two directions are toward the minimum opening planes **11** and **21** and four directions are toward the respective grooves **14.** In other words, the supply path of fluid into the chip holding space **121** and the exhaust path of fluid from the chip holding space **121** are secured in multiple directions, so that the flexibility of fluid supply and exhaustion can be improved dramatically. Thus, the supply efficiency and the exhaust efficiency of fluid into and from the chip holding space **121,** or the displacement efficiency of fluid is still further enhanced, so that the treatment efficiency of an object to be cleaned such as the chip 4 is still further enhanced.

Moreover, in the second embodiment, as shown in, for example, FIG. **5B,** in the chip holder **10** made by assembling the lower holder plate 1 and the upper holder plate **2,** a side edge thereof is formed with a gap of a predetermined height made by uniting the grooves **14** and **24.** This regulates fluid at the side edge of the chip holder **10** to facilitate entering of the fluid into the grooves **14** and **24.** Therefore, the synergy effect by the groove **14** connecting the adjacent first conical holes **12** and the groove **24** connecting the adjacent third conical holes **22** enhances the displacement efficiency of the fluid. Therefore, the treatment efficiency of an object to be treated, for example, the chip **4** can be still further enhanced.

In the second embodiment, the perimeter of the lower holder plate **1** is provided with a level difference so that the upper surface of the perimeter is flush with the bottom surface of the groove **14.** Instead of this, the level difference may be provided so that the bottom surface of the groove **14** is higher than the upper surface of the perimeter of the lower holder plate **1.** Likewise, the perimeter of the upper holder plate **2** is provided with a level difference so that the lower surface of the perimeter is flush with the bottom surface of the groove **24** (the top surface in this figure). Alternatively, the level difference may be provided so that the bottom surface of the groove **24** (the top surface in this figure) is lower than the lower surface of the perimeter of the upper holder plate **2.**

In the second embodiment, the lower holder plate **1** is provided with the groove **14** and the upper holder plate **2** is provided with the groove **24.** Instead of this, either of the lower holder plate **1** and the upper holder plate **2** may be provided with no groove. In addition, the level difference is provided on both of the perimeters of the lower holder plate **1** and the upper holder plate **2.** Alternatively, no level difference may be provided on both or either of the lower holder plate **1** and the upper holder plate **2.**

(Third Embodiment)

Hereinafter, a chip holder and a chip treatment method (specifically, chip cleaning method) according to a third embodiment of the present invention will be described with reference to the accompanying drawings.

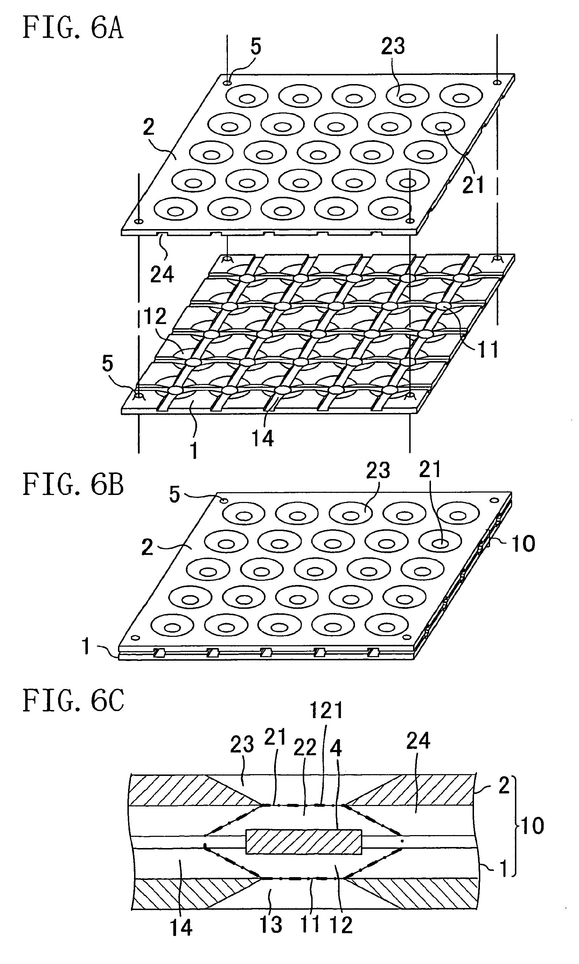

FIGS. **6A** and **6B** are views showing a schematic structure of a chip holder according to the third embodiment. FIG. **6A** shows the chip holder in the state prior to assembly of a lower holder plate and an upper holder plate, while FIG. **6B** shows the chip holder in the state subsequent to the assembly of those plates.

FIG. **6C** is a view showing a cross-sectional structure of through hole formation regions of the lower and upper holder plates of the chip holder according to the third embodiment. FIG. **6C** shows the chip holder in the state subsequent to assembly of the lower and upper holder plates.

Note that the description of the components shown in FIGS. **6A** to **6C** that are the same as those of the second embodiment shown in FIGS. **5A** to **5D** will be omitted by retaining the same reference numerals.

The third embodiment differs from the second embodiment in the point as follows. Specifically, in the second embodiment, the perimeter of the lower holder plate **1** is provided with a level difference so that the upper surface of the perimeter is flush with the bottom surface of the groove **14,** and the perimeter of the upper holder plate **2** is provided with a level difference so that the lower surface of the perimeter is flush with the bottom surface of the groove **24** (the top surface in this figure). In contrast to this, in the third embodiment, no level differences are provided in the respective perimeters of the lower and upper holder plates **1** and **2.** Instead of this, in the third embodiment, as shown in FIG. **6A,** for example, a projection from the upper surface of the lower holder plate **1** is provided around the set screw holes **5** of the plate **1,** and a projection from the lower surface of the upper holder plate **2** is provided around the set screw holes **5** of the plate **2.** Thereby, when the lower and upper holder plates **1** and **2** are assembled to form the chip holder **10,** a gap of a predetermined height is created between the lower and upper holder plates **1** and **2.** When the chip holder of the third embodiment is used for cleaning of chips having a dimension of, for example, 2 mm (width) x 2 mm (length) $\times$ 0.4 mm (thickness), the grooves **14** and **24** have a width of, for example, 1.0 mm and a depth of, for example, 0.4 mm. In this case, the gap mentioned above has a height smaller than the thickness of the chip **4** (0.4 mm), for example, a height of 0.2 mm. In addition, in this case, the bottom plane of the first conical hole **12** (the maximum opening plane in the upper surface of the lower holder plate **1)** has a diameter of, for example, 3.4 mm, and the top plane of the first conical hole **12** (the minimum opening plane **11** at the interface between the upper and lower surfaces of the lower holder plates **1)** has a diameter of, for example, 2.0 mm. The second, third, and fourth conical holes **13, 22,** and **23** have the same shape as the first conical hole **12.**

Also in the third embodiment, as shown in FIGS. **6A** to **6C,** the groove **14** connects adjacent first conical holes **12** to extend to a side edge of the lower holder plate **1,** and the groove **24** connects adjacent third conical holes **22** to extend to a side edge of the upper holder plate **2.**

With the chip holder and the chip treatment method using that holder described above according to the third embodiment, in addition to the same effects as the first embodiment, the following effects can be exerted. To be more specific, within the chip holding space **121** formed of the first and third conical holes **12** and **22** provided through the lower and upper holder plates **1** and **2,** respectively, fluid such as cleaning liquid can come from and go to every direction through the grooves **14** and **24** and a gap between the lower and upper holder plates **1** and **2.** This dramatically improves the flexibility of fluid supply and exhaustion. In addition, the effect of fluid regulation facilitates entering of the fluid into the grooves **14** and **24.** Thus, the supply efficiency and the exhaust efficiency of fluid into and from the chip holding space **121,** or the displacement efficiency of fluid is still further enhanced, so that the treatment efficiency for an object to be cleaned such as the chip **4** is still further enhanced.

In the third embodiment, a gap of a height smaller than the thickness of the object to be treated (for example, the thickness of the chip **4)** is provided between the lower and upper holder plates **1** and **2.** In addition to this, similarly to the second embodiment, a level difference may be provided in the perimeter of at least either of the lower holder plate **1** and the upper holder plate **2.** This provides a more significant effect of fluid regulation.

Moreover, in the third embodiment, in order to create a gap between the lower and upper holder plates **1** and **2,** a projection from the upper surface of the lower holder plate **1** is provided around the set screw holes **5** of the plate **1,** and a projection from the lower surface of the upper holder plate **2** is provided around the set screw holes **5** of the plate **2.** However, the approach to creating a gap between the lower and upper holder plates **1** and **2** is not limited to this, and, for example, the projection mentioned above may be provided in other points of the upper surface of the lower holder plate 1 and the lower surface of the upper holder plate **2** (other points except the vicinities of the set screw holes **5).**

In the third embodiment, the lower holder plate 1 is provided with the groove **14,** and the upper holder plate **2** is provided with the groove **24.** Instead of this, either of the lower holder plate **1** and the upper holder plate **2** may be provided with no groove.

(Fourth Embodiment)

Hereinafter, a chip holder and a chip treatment method (specifically, chip cleaning method) according to a fourth embodiment of the present invention will be described with reference to the accompanying drawings.

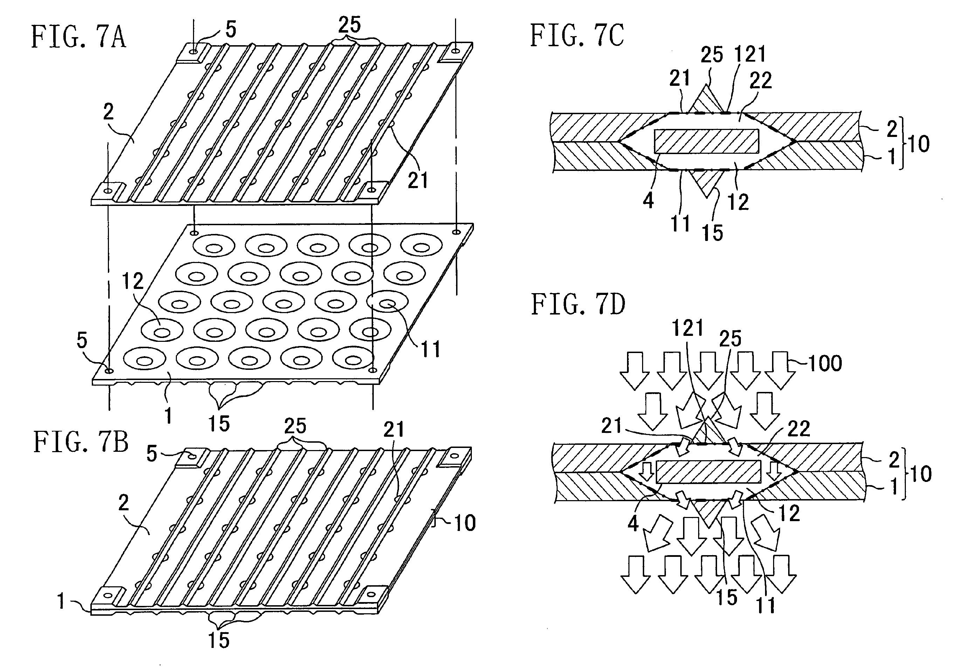

FIGS. **7A** and **7B** are views showing a schematic structure of a chip holder according to the fourth embodiment. FIG. **7A** shows the chip holder in the state prior to assembly of a lower holder plate and an upper holder plate, while FIG. **7B** shows the chip holder in the state subsequent to the assembly of those plates.

FIG. **7C** is a view showing a cross-sectional structure of through hole formation regions of the lower and upper holder plates of the chip holder according to the fourth embodiment. FIG. **7C** shows the chip holder in the state subsequent to the assembly of the lower and upper holder plates.

FIG. **7D** is a schematic view showing the flow of fluid supplied and exhausted in a cleaning treatment using a chip holder **10** according to the fourth embodiment shown in FIGS. **7A** to **7C.**

Note that the description of the components shown in FIGS. **7A** to **7D** that are the same as those of the first embodiment shown in **FIGS. 1A** to **1D** will be omitted by retaining the same reference numerals.

A first point of the fourth embodiment different from the first embodiment is the shape of through holes provided through the lower holder plate **1** and the upper holder plate **2,** respectively, as shown in FIGS. **7A** to **7C.** To be more specific, in the first embodiment, as shown in FIGS. **1C** and **1D**, the first through hole formed of the first and second conical holes **12** and **13** is provided through the lower holder plate **1,** and the second through hole formed of the third and fourth conical holes **22** and **23** is provided through the upper holder plate **2.** On the other hand, in the fourth embodiment, as shown in FIGS. **7A** to **7C,** a first through hole formed only of the first conical hole **12** is provided through the lower holder plate **1,** and a second through hole formed only of the third conical hole **22** is provided through the upper holder plate **2.** That is to say, a maximum opening plane of the first conical hole **12** as the first through hole is positioned on the upper surface side of the lower holder plate **1,** and a minimum opening plane **11** of the first conical hole **12** is positioned on the lower surface side of the lower holder plate **1.** Also, a maximum opening plane of the third conical hole **22** as the second through hole is positioned on the lower surface side of the upper holder plate **2,** and a minimum opening plane **21** of the third conical hole **22** is positioned on the upper surface side of the upper holder plate **2.** Also in the fourth embodiment, similarly to the first embodiment, as shown in FIG. **7C,** the chip **4** is held in the chip holding space **121** formed of the first conical hole (first through hole) **12** provided through the lower holder plate **1** and the third conical hole (second through hole) **22** provided through the upper holder plate **2.**

A second point of the fourth embodiment different from the first embodiment is that on the lower surface of the lower holder plate **1,** bars (lower plate bars) **15** are provided which cover portions of the first through holes (first conical holes **12),** and that on the upper surface of the upper holder plate **2,** bars (upper plate bars) **25** are provided which cover portions of the second through holes (third conical holes **22).** From this, each of the minimum opening planes **11** of the first conical holes **12** in the lower surface of the lower holder plate **1** can be prevented from being full open, and each of the minimum opening planes **21** of the third conical holes **22** in the upper surface of the upper holder plate **2** can be prevented from being full open. When the chip holder of the fourth embodiment is used for cleaning of chips having a dimension of, for example, 2 mm (width) x 2 mm (length) $\times$ 0.4 mm (thickness), the bars **15** and **25** have a width of, for example, 1.0 mm and a height of, for example, 1.0 mm.

In the chip holder **10** of the fourth embodiment, as shown in FIG. 7D, a portion of the minimum opening plane **21** is covered with the bar **25.** Therefore, for example, fluid **100** such as cleaning liquid flowing through the minimum opening plane **21** toward the chip holding space **121** can enter the third conical hole **22,** that is, the chip holding space **121** without giving any direct impact to the center portion of the chip **4.**

With the chip holder and the chip treatment method using that holder described above according to the fourth embodiment, in addition to the same effects as the first embodiment, the following effects can be exerted. To be more specific, an impact can be softened which is given to an object to be treated (for example, the chip **4)** by fluid introduced into the chip holding space **121.** Therefore, even if the object to be treated is a structurally-weak device, breakage of the device can be prevented and concurrently the displacement efficiency and the exhaust efficiency of fluid within the chip holding space **121** can be enhanced. This improves the cleaning efficiency of the device. Accordingly, it is especially useful to employ the chip holder **10** of the fourth embodiment for the treatment for a structurally-weak object to be treated. Specifically, for example, when the chip holder **10** of the fourth embodiment is employed for cleaning (wet etching) for forming a cavity which has a dimension of about 1500 $\mu$m (width) x 1500 $\mu$m (length) x 3 $\mu$m (height) and which is covered with a thin film of a thickness of 100 nm or smaller or for cleaning or the like of a MEMS device with a structurally-unstable shape formed thereon, manufacturing yields can be improved dramatically.

In the fourth embodiment, the bars **15** covering portions of the first through holes (first conical holes **12)** are provided on the lower surface of the lower holder plate **1,** and the bars **25** covering portions of the second through holes (third conical holes **22)** are provided on the upper surface of the upper holder plate **2.** Instead of this, only bars may be provided which cover portions of through holes used as holes for introducing fluid such as cleaning liquid.

In the fourth embodiment, a dummy bar may be provided on regions of the lower surface of the lower holder plate **1** and the upper surface of the upper holder plate **2** on which no through hole is formed, depending on circumstances where, for example, the bars **15** and **25** are processed integrally with the lower holder plate **1** and the upper holder plate **2,** respectively.

The dimension of the object to be cleaned shown in the first to fourth embodiments (for example, the dimension of the chip **4)** and the dimension of the chip holding space **121** (that is, respective dimensions of the first and third conical holes **12** and **22)** are given merely as an example. As long as the object to be cleaned is constructed not to go out of the chip holding space **121,** the dimensions of the object to be cleaned and the chip holding space **121** are not limited to any particular value.

Next description will be made of the condition in which the chip **4** as an object to be cleaned does not go out of the chip holding space **121** in the case where the chip **4** is square in planer shape and the minimum opening planes **11** and **21** of the conical holes **12** and **22** forming the chip holding space **121** are circular (other than elliptical) in shape. This description will be made with reference to FIGS. **1A** to **1D.** Note that the conical holes **12** and **22** are set to have the same dimension, and the minimum opening planes **11** and **21** are also set to have the same dimension.

In the above case, for example, by setting the length of the sides of the chip **4** at a value larger than the diameters of the minimum opening planes **11** and **21,** the chip **4** can be physically prevented from going out of the chip holding space **121.** In this situation, the cone angles of the conical holes **12** and **22** (the angles of the cone points in the case where it is assumed that the conical holes **12** and **22** have cone points) are set within the range of, for example, about 110 to 160°. To be more specific, in order to limit the movable space of the chip **4** so that the chip **4** can tilt only up to about 30° with respect to the horizontal plane within the chip holding space **121,** the cone angles of the conical holes **12** and **22** are set within the range mentioned above. The thicknesses of the lower and upper holder plates **1** and **2** are set so that the cone angles of the conical holes **12** and **22** are set at appropriate angles described above.

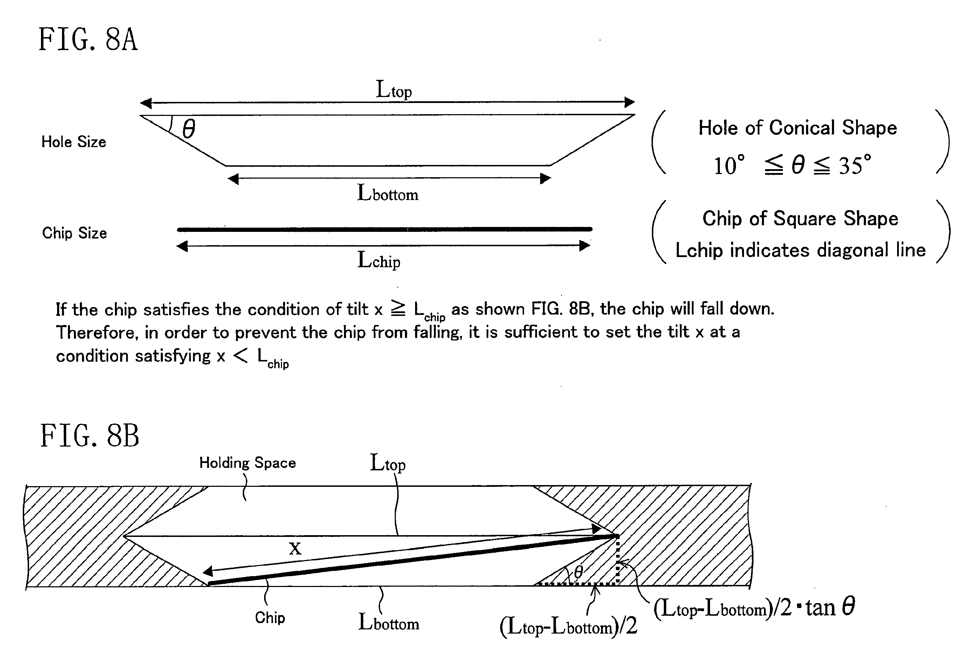

Next description will be made of the condition in which the chip as an object to be cleaned does not go out of the chip holding space in the case where the chip is square in planer shape, the chip holding space is formed of conical holes similar to the conical holes **12** and **22** of the first embodiment, and the thickness of the chip can be ignored. This description will be made with reference to FIGS. **8A** and **8B.** In this description, referring to FIG **8A,** the maximum opening plane and the minimum opening plane of the conical hole have diameters of $L_{top}$ and $L_{bottom}$, respectively. The angle which the maximum opening plane of the conical hole forms with the wall thereof is set at $\theta$ (where $10° \leq \theta \leq 35°$), and the length of the diagonal line of the chip is set at $L_{chip}$.

As shown in FIG. **8B,** when the distance from one end of the maximum opening plane to the other end of the minimum opening plane located opposite from the maximum opening plane is set at x, the condition in which the tilted chip does not go out of the chip holding space is $x < L_{chip}$. And x can be represented as

$$x = [\{L_{bottom} + (L_{top} - L_{bottom})/2\}^2$$

$$+ \{(L_{top} - L_{bottom})/2 \cdot \tan\theta\}^2]^{0.5}$$

$$= [\{(L_{top} + L_{bottom})^2 + (L_{top} - L_{bottom})^2\}/4 + \tan^2\theta]^{0.5}$$

$$= [\{(L_{top}^2 + L_{bottom}^2)/2 + \tan^2\theta]^{0.5}$$

Therefore, the condition $x < L_{chip}$ can be represented as

$$[\{(L_{top}^2 + L_{bottom}^2)/2 + \tan^2\theta]^{0.5} < L_{chip}$$

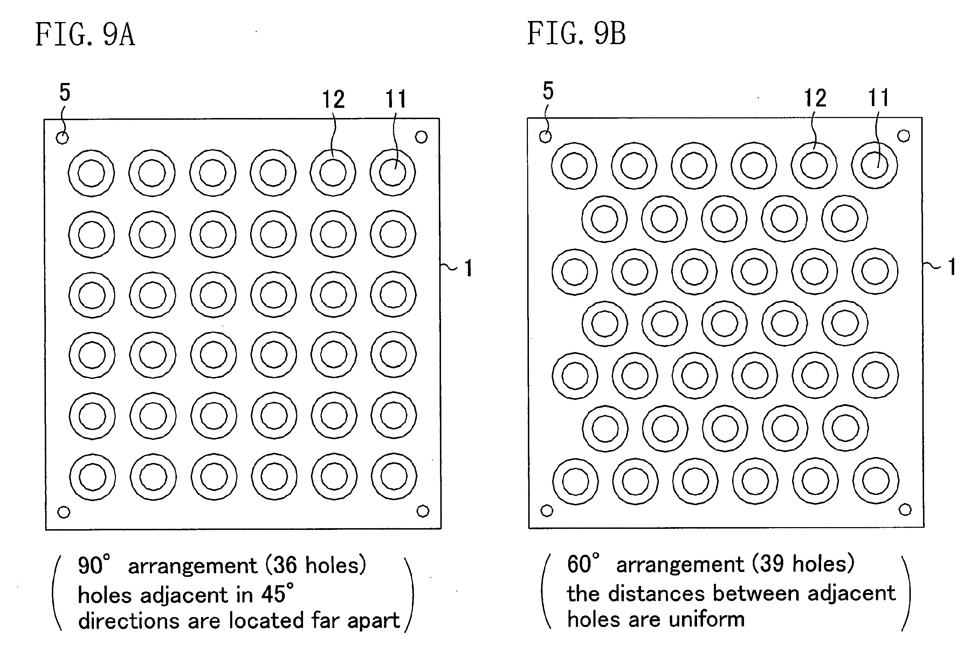

In the first to fourth embodiments, as shown in FIG. **9A,** the chip holding spaces **121** (that is, the first conical hole **12** of the lower holder plate **1** and the third conical hole **22** of the upper holder plate **2:** only the first conical hole **12** is shown in FIG. **9A)** are arranged in a grid pattern (90° arrangement). In this case, as compared to the distance between the first conical holes **12** adjacent to each other in the grid directions (90° directions), the distance between the first conical holes **12** adjacent to each other in oblique directions (45° directions) is longer. As a result of this, if the first conical holes **12** are arranged, for example, six each in one grid direction, the total number of the first conical hole **12** in the lower holder plate **1** is 36. However, arrangement of the first conical holes **12,** that is, arrangement of the chip holding spaces **121** is not limited to any particular form. For example, as shown in FIG. **9B,** all the distances between the adjacent first conical holes **12** may be set to be equal by displacing on of adjacent rows of the holes **12** from the other (60° arrangement) in the array of the first conical holes **12** shown in FIG. **9A.** With this arrangement, as shown in FIG. **9B,** the total number of first conical holes **12** in the lower holder plate **1** can be increased to 39. Accordingly, by employing the arrangement of the first conical holes **12** shown in FIG. **9B,** that is, the arrangement of the chip holding spaces, more chip holding spaces can be formed within the chip holder and the area occupied by the through hole opening planes of the lower surface of the lower holder plate **1** and the upper surface of the upper holder plate **2** increases. Therefore, the displacement efficiency of fluid within the chip holding space can be further improved.

In the first to fourth embodiments, it is preferable to use, for example, resin resistant to chemicals as the material for the chip holder **10** because the chip holder **10** has to be immersed in cleaning liquid. To be more specific, if hydrofluoric acid is used as the cleaning liquid, it is desirable to use PEEK (PolyEther Ether Ketone) as the material for the chip holder **10.** Or, if another type of cleaning liquid is used as the cleaning liquid, PFA (Tetrafluoroethylene Perfluoroalkyl Vinyl Ether Copolymer), PTFE (Polytetrafluoroethylene), or the like can also be used according to the cleaning liquid.

In the first to fourth embodiments, under the assumption that an object to be treated is a square chip, the chip holding space **121** is set to have a circular planer shape. However, the planer shape of the chip holding space **121** is not limited to any particular shape, and an ellipse or a polygon may be used instead of a circle. For example, if an object to be treated is a rectangular chip, the chip holding space **121** may have an elliptical planer shape. Accordingly, the chip holding space **121** and the object to be treated preferably differ in planer shape. With this configuration, when the object to be treated comes into contact with a wall of the first conical hole **12** or the third conical hole **22** forming the chip holding space **121,** the contact is always made in a point-contact state. Thus, the object to be treated can be reliably held in the chip holding space **121** in a point-contact or non-contact state. This allows certain enhancement of the displacement efficiency and the exhaust efficiency of fluid such as cleaning liquid introduced into the holding space **121,** which certainly improves the cleaning efficiency of the object to be treated. To be more specific, if an object to be treated is a quadrangular chip, the planer shape of the chip holding space **121** is preferably a circle, an ellipse, or a polygon with five or more corners. In other words, as long as the object to be treated is held in the chip holding space **121** in a point-contact or non-contact state, a hole in the shape of polygonal pyramid or the like other than the conical hole can be used as a through hole forming the chip holding space **121.**

In the first to fourth embodiments, in the chip cleaning method using the chip holder **10,** cleaning equipment is employed which manually carries out transfer of the chip holder **10** and supply and exhaust of fluid such as cleaning liquid. Alternatively, it goes without saying that instead of this, cleaning equipment may be employed of which system for transferring the chip holder **10** or mechanism for supplying and exhausting fluid is automated.

In the chip holding space **121** of the chip holder **10** according to the first to fourth embodiments, the side of the space closer to the minimum opening plane **21** is used as a hole for introducing fluid, and the side thereof closer to the minimum opening plane **11** is used as a hole for exhausting fluid. Instead of this, the side of the space closer to the minimum opening plane **21** may be used as a hole for exhausting fluid, and the side thereof closer to the minimum opening plane **11** may be used as a hole for introducing fluid.

In the first to fourth embodiments, exemplary description has been made of the case where chip cleaning is carried out using the chip holder **10.** Alternatively, chip drying may be carried out using the chip holder **10.** In this case, the contact area of the chip holder **10** with the object to be treated is small, so that a sufficient drying of the object to be treated can be carried out. This provides a reliable prevention of a situation in which possible troubles occur in later processes.

**Claims**

**1.**  A chip holder comprising:

a lower holder plate with a first through hole; and an upper holder plate with a second through hole,

wherein an object to be treated is held movably in a holding space formed of the first through hole and the second through hole in assembling the lower holder plate and the upper holder plate.

**2.**  The chip holder of claim 1,
wherein the first through hole includes: a first maximum opening plane having, in an upper surface of the lower holder plate, an area equal to or larger than the maximum projection area of the object to be treated; and a first minimum opening plane having, between the upper and lower surfaces of the lower holder plate, a smaller area than the maximum projection area, and

the second through hole includes: a second maximum opening plane having, in a lower surface of the upper holder plate, an area equal to or larger than the maximum projection area; and a second minimum opening plane having, between the upper and lower surfaces of the upper holder plate, a smaller area than the maximum projection area.

3. The chip holder of claim 2,
wherein in the lower surface of the lower holder plate, the first through hole has a larger opening plane than the first minimum opening plane.

4. The chip holder of claim 2,
wherein in the upper surface of the upper holder plate, the second through hole has a larger opening area than the second minimum opening area.

5. The chip holder of claim 2,
wherein in the upper surface side of the lower holder plate, the first through hole includes a lower-plate conical hole with no cone point,
in the lower surface side of the upper holder plate, the second through hole includes an upper-plate conical hole with no cone point,
the first maximum opening plane is the bottom of the lower-plate conical hole, and the second maximum opening plane is the bottom of the upper-plate conical hole.

6. The chip holder of claim 1,
wherein the upper surface of the lower holder plate is provided with a groove extending from the first through hole to a side edge of the lower holder plate.

7. The chip holder of claim 6,
wherein the lower holder plate has another through hole adjacent to the first through hole, and
the groove extends from the first through hole to another said through hole.

8. The chip holder of claim 6,
wherein an outermost perimeter of the upper surface of the lower holder plate is provided with a level difference.

9. The chip holder of claim 1,
wherein the lower surface of the upper holder plate is provided with a groove extending from the second through hole to a side edge of the upper holder plate.

10. The chip holder of claim 9,
wherein the upper holder plate has another through hole adjacent to the second through hole, and
the groove extends from the second through hole to another said through hole.

11. The chip holder of claim 9,
wherein an outermost perimeter of the lower surface of the upper holder plate is provided with a level difference.

12. The chip holder of claim 1,
wherein with the lower and upper holder plates assembled, a gap of a height smaller than the thickness of the object to be treated is created between the lower and upper holder plates.

13. The chip holder of claim 1,
wherein a bar covering a portion of the first through hole is provided on the lower surface of the lower holder plate.

14. The chip holder of claim 1,
wherein a bar covering a portion of the second through hole is provided on the upper surface of the upper holder plate.

15. The chip holder of claim 1,
wherein the object to be treated differs from the holding space in planer shape.

16. The chip holder of claim 15,

wherein the planer shape of the object to be treated is a quadrangle, and the planer shape of the holding space is a circle, an ellipse, or a polygon with five or more corners.

17. A chip treatment method for carrying out treatment on the object to be treated with the object to be treated held in the chip holder of claim 1.

18. The method of clam 17,
wherein during the treatment, the object to be treated is cleaned by subjecting the object to be treated to fluid, or the object to be treated is dried.

FIG. 1C

FIG. 1D

FIG. 1A

FIG. 1B

FIG. 2

FIG. 3

FIG. 4A

FIG. 4B

FIG. 5A

FIG. 5B

FIG. 5C

FIG. 5D

EP 1 703 544 A2

FIG. 6A

FIG. 6B

FIG. 6C

FIG. 7A

FIG. 7C

FIG. 7B

FIG. 7D

EP 1 703 544 A2

# FIG. 8A

Hole Size

$L_{top}$

$\theta$

$L_{bottom}$

$$\left( \begin{array}{c} \text{Hole of Conical Shape} \\ 10° \leqq \theta \leq 35° \end{array} \right)$$

Chip Size

$L_{chip}$

$$\left( \begin{array}{c} \text{Chip of Square Shape} \\ \text{Lchip indicates diagonal line} \end{array} \right)$$

If the chip satisfies the condition of tilt $x \geqq L_{chip}$ as shown FIG. 8B, the chip will fall down. Therefore, in order to prevent the chip from falling, it is sufficient to set the tilt x at a condition satisfying $x < L_{chip}$

# FIG. 8B

Holding Space    $L_{top}$

x

Chip    $L_{bottom}$

$\theta$

$(L_{top}-L_{bottom})/2$

$(L_{top}-L_{bottom})/2 \cdot \tan \theta$

EP 1 703 544 A2

# FIG. 9A

$\left(\begin{array}{l}\text{90° arrangement (36 holes)}\\\text{holes adjacent in 45°}\\\text{directions are located far apart}\end{array}\right)$

# FIG. 9B

$\left(\begin{array}{l}\text{60° arrangement (39 holes)}\\\text{the distances between adjacent}\\\text{holes are uniform}\end{array}\right)$

EP 1 703 544 A2

# FIG. 10A
PRIOR ART

38c  37        38c  37        38c  37                    36

31      38a        31      38a        31      38a

33            33            33        32

# FIG. 10B
PRIOR ART

37          37          37          36

33  31      33  31      33  31      32

# FIG. 10C
PRIOR ART

37  39f      37  39e      37  39d      36

39a  33  31    39b  33  31    39c  33  31    32

FIG. 11
PRIOR ART

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H7176511 A